# EUROPÄISCHE PATENTSCHRIFT

(11) **EP 0 765 894 B1**
(45) Veröffentlichungstag und Bekanntmachung des Hinweises auf die Patenterteilung: **28.02.2001**
(21) Anmeldenummer: 96113266.9
(22) Anmeldetag: 19.08.1996
(51) Int. Cl.: C08G 73/22, C08G 75/32, G03F 7/038

(54) **Herstellung von Poly-o-hydroxyamiden und Poly-o-mercaptoamiden**
Process for the preparation of poly-o-hydroxyamides and poly-o-mercaptoamides
Procédé pour la préparation de poly-o-hydroxyamides et de poly-o-mercaptoamides

(30) Priorität: 31.08.1995 DE 19532175
(43) Veröffentlichungstag der Anmeldung: 02.04.1997
(73) Patentinhaber: Infineon Technologies AG, 81541 München (DE)
(72) Erfinder: Sezi, Recai, Dr., 91341 Röttenbach (DE); Ahne, Hellmut, Dr., 91341 Röttenbach (DE); Gestigkeit, Roland, Dipl.-Chem., 90478 Nürnberg (DE); Geibel, Kurt, Prof. Dr., 91093 Hessdorf (DE)
(74) Vertreter: Zedlitz, Peter, Dipl.-Inf.

(56) Entgegenhaltungen:
- EP-A- 0 391 196
- EP-A- 0 436 457
- US-A- 5 322 916

## Beschreibung

Die Erfindung betrifft ein Verfahren zur Herstellung von Poly-o-hydroxyamiden (Polybenzoxazol-Vorstufen) und Poly-o-mercaptoamiden (Polybenzothiazol-Vorstufen).

In der Mikroelektronik werden hochwärmebeständige Polymere benötigt, insbesondere als Schutz- und Isolierschichten bzw. als Dielektrika (siehe dazu beispielsweise: "SAMPE Journal", Vol. 25 (1989), No. 6, Seiten 18 bis 23, und "Proceedings of the 1992 International Conference on Multichip Modules", Seiten 394 bis 400). Einige der verwendeten Polymere, beispielsweise Homo- und Copolymere aromatischer Polyether sowie Vorstufen von Polyimiden (PI) und Polybenzoxazolen (PBO), weisen eine gute Löslichkeit in organischen Lösungsmitteln und gute Filmbildungseigenschaften auf und können mittels Schleudertechnik auf elektronische Bauteile aufgebracht werden (siehe dazu beispielsweise: "High Performance Polymers", Vol. 4 (1992), No. 2, Seiten 73 bis 80, und "Polymers for Advanced Technologies", Vol. 4 (1993), Seiten 217 bis 233).

Polymer-Vorstufen der genannten Art werden durch eine Temperaturbehandlung cyclisiert, d.h. in die entsprechenden Polymere (PI bzw. PBO) umgewandelt; dabei ergeben sich die endgültigen Eigenschaften. Durch die Cyclisierung verschwinden nämlich die hydrophilen Gruppierungen des Poly-o-hydroxyamids, d.h. die NH-, OH- und CO-Gruppen, welche die dielektrischen Eigenschaften und die Wasseraufnahme negativ beeinflussen würden. Dies ist beispielsweise ein wesentlicher Vorteil der Polybenzoxazole gegenüber den Polyimiden (mit zwei CO-Gruppen pro Imideinheit) und insbesondere gegenüber den Hydroxypolyimiden (mit zwei CO-Gruppen und einer OH-Gruppe pro Imideinheit). Außerdem ist die Cyclisierung nicht nur für die guten dielektrischen Eigenschaften und die geringe Wasseraufnahme des Endproduktes wichtig, sondern auch für dessen hohe Temperaturstabilität.

PI- und PBO-Vorstufen können, beispielsweise durch Zusatz geeigneter photoaktiver Komponenten, photosensitiv eingestellt und dann direkt strukturiert werden, d.h. ohne die Verwendung eines Hilfsresists. Dies ist deswegen bedeutsam, weil die direkte Strukturierung - im Vergleich mit der indirekten Strukturierung - erhebliche Kostenvorteile bietet.

Photosensitive PBO-Vorstufen bieten, im Gegensatz zu den meisten photosensitiven PI-Vorstufen, die Vorteile der positiven Strukturierbarkeit, wie geringere Defektdichte bei der Strukturierung der sogenannten "via holes", weil - im Vergleich mit negativ arbeitenden Systemen - nur ein Bruchteil der Fläche belichtet wird. Beim Einsatz alkalilöslicher PBO-Vorstufen ergibt sich außerdem die Möglichkeit einer wäßrig-alkalischen Entwicklung. Nach der Photostrukturierung erfolgt dann die Cyclisierung der Vorstufen durch Temperung.

Wäßrig-alkalisch entwickelbare PBO-Vorstufen sind bereits bekannt (siehe dazu: EP-PS 0 023 662, EP-OS 0 264 678 und EP-PS 0 291 779). Der dabei angewendete photolithographische Prozeß ist, bis auf die Cyclisierung, der gleiche wie bei der Strukturierung bekannter Positivresists auf der Basis von Novolaken und Chinonaziden, eines weltweit in zahlreichen Fertigungslinien eingesetzten Prozesses (siehe dazu beispielsweise: D.S. Soane und Z. Martynenko "Polymers in Microelectronics - Fundamentals and Applications", Elsevier, Amsterdam 1989, Seiten 77 bis 124).

Die Alkalilöslichkeit der PBO-Vorstufen ist eine wichtige Voraussetzung für deren Einsatz als Basispolymer für wäßrig-alkalisch entwickelbare photosensitive Dielektrika. Für mikroelektronische Anwendungen müssen die Vorstufen in metallionenfreien Entwicklern löslich sein, damit derartige Entwickler auch bei der Photostrukturierung verwendet werden können. Entwickler, welche Metallionen enthalten, können nämlich die elektrische Funktion der Bauteile negativ beeinflussen.

Die gängigste Methode zur Herstellung von alkalilöslichen PBO-Vorstufen, d.h. von Poly-o-hydroxyamiden, ist die Umsetzung eines Dicarbonsäurechlorids mit einem geeigneten Bis-o-aminophenol. Zum Abfangen des bei der Reaktion entstehenden Chlorwasserstoffs wird in der Regel eine lösliche Base, wie Pyridin, zugesetzt (siehe: EP-OS 0 264 678 und EP-PS 0 291 779). Nach dieser Methode sind nun zwar Vorstufen herstellbar, welche in metallionenfreien wäßrig-alkalischen Entwicklern löslich sind, von Nachteil ist jedoch, daß Chloridionen im Polymer verbleiben. Ein derartiges Polymer ist aber als Beschichtungsmaterial für mikroelektronische Bauteile nicht brauchbar, weil die Chloridionen Korrosion verursachen und die Funktion der Bauteile somit stark beeinträchtigen können. Es ist deshalb eine Reinigung des Polymers mittels Ionenaustauscher erforderlich. Diese Reinigung ist jedoch aufwendig und teuer, sie umfaßt nämlich zusätzliche Prozeßschritte, wie die Vorbereitung der Ionenaustauschersäule, das Lösen des Polymers, das Durchlaufen der Lösung durch die Säule und das Nachwaschen sowie die erneute Ausfällung und Trocknung.

Bei der Herstellung von Poly-o-hydroxyamiden muß auch die Forderung erfüllt werden, daß das Dicarbonsäurechlorid vorwiegend mit den Aminogruppen des Bis-o-aminophenols reagiert (unter Amidbildung), nicht aber mit dessen Hydroxylgruppen (unter Esterbildung), d.h. die Reaktionsselektivität der Amidbildung gegenüber der Esterbildung muß hoch sein. Kann die Esterbildung nicht ausgeschlossen bzw. stark unterdrückt werden, dann führt dies zu unzureichend alkalilöslichen Polymeren. Eine geringe Reaktionsselektivität kann ferner zu einer Gelbildung in der Polymerlösung führen, wobei das hergestellte Poly-o-hydroxyamid dann unfiltrierbar und somit unbrauchbar ist.

Es wurden auch bereits Verfahren zur chloridfreien Synthese von Poly-o-hydroxyamiden - und ebenso von Poly-o-mercaptoamiden - beschrieben. So ist es aus der EP-OS 0 158 726 bekannt, Dihydroxy- bzw. Dimercaptodiaminoverbindungen in Gegenwart eines Carbodiimids mit einer Dicarbonsäure umzusetzen. Bei dieser Reaktion bereiten jedoch Harnstoffreste, die aufgrund einer Umlagerungsreaktion am Harz verbleiben, oft Probleme. Sie beeinträchtigen nämlich die thermische Beständigkeit des Polybenzoxazols bzw. Polybenzothiazols sowie die Qualität der daraus hergestellten Schichten. Außerdem sind die nach diesem Verfahren hergestellten Polymere in metallionenfreien wäßrig-alkalischen Entwicklern nicht ausreichend löslich.

Ein alternatives chloridfreies Herstellungsverfahren für Poly-o-hydroxyamide besteht darin, zur Umsetzung der Dicarbonsäure mit dem Bis-o-aminophenol Kondensationsreagenzien wie 1-Ethoxycarbonyl-2-ethoxy-1,2-dihydrochinolin und 1,1'-Carbonyldioxy-di-1,2,3-benzotriazol einzusetzen (siehe: EP-OS 0 391 196). Die auf diese Weise hergestellten Polymere zeigen aber in metallionenfreien wäßrig-alkalischen Entwicklern ebenfalls nur eine unzureichende Löslichkeit.

Es sind auch Verfahren bekannt, bei denen die Amidbildung mittels Phosphorverbindungen erfolgt (siehe dazu: EP-OS 0 481 402, US-PS 4 331 592 und DE-OS 37 16 629). Bei Poly-o-hydroxyamiden führen derartige Synthesen aber entweder zu cyclisierten, d.h. alkaliunlöslichen Produkten oder es verbleiben im Polymer phosphorhaltige, teilweise auch chemisch gebundene Reste, wodurch das Polymer, wegen der Dotierungseigenschaften von Phosphor, für mikroelektronische Anwendungen unbrauchbar wird. Im Gegensatz zu ionischen Verunreinigungen können nämlich derartige Reste beispielsweise nicht mittels Ionenaustauscher entfernt werden.

Aufgabe der Erfindung ist es, ein kostengünstiges Verfahren anzugeben, mit dem - auf chloridfreiem Weg - Poly-o-hydroxyamide und Poly-o-mercaptoamide hergestellt werden können, welche in metallionenfreien wäßrig-alkalischen Entwicklern löslich sind.

Dies wird erfindungsgemäß dadurch erreicht, daß ein Bis-o-aminophenol bzw. ein Bis-o-aminothiophenol bei einer Temperatur ≤ 0°C mit einem gemischten Dianhydrid aus einer Dicarbonsäure und einer Sulfonsäure und mit folgender Struktur umgesetzt wird:

E-SO₂-O-CO-R*-CO-O-SO₂-E ,

wobei folgendes gilt: 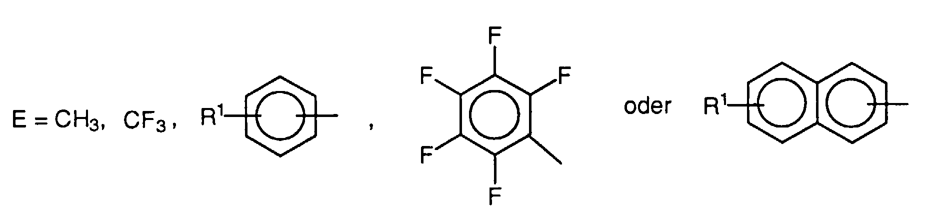 mit R¹ = H, F, CH₃ oder CF₃;
R* hat folgende Bedeutung:
- (CR₂)ₘ mit R = H, F, CH₃ oder CF₃
und m = 1 bis 10; 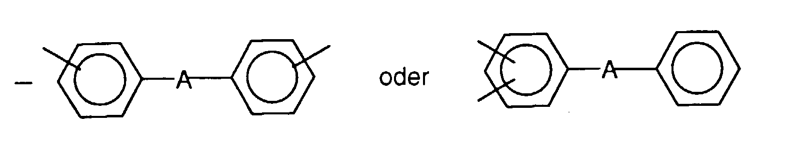 mit
- A =: (CH₂)ₙ, (CF₂)ₚ, C(CH₃)₂, C(CF₃)₂, C(CH₃)(C₆H₅), C(CF₃)(C₆H₅), C(CF₃)(C₆F₅), C(C₆H₅)₂, CF₂-CF(CF₃), CH=CH, CF=CF, C≡C, O-C₆H₄-O, O, S, CO oder SO₂, wobei n = 0 bis 10 und p = 1 bis 10; 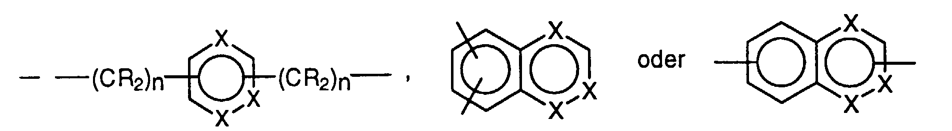
mit
X = CH oder N
R = H, F, CH₃ oder CF₃
und n = 0 bis 10; 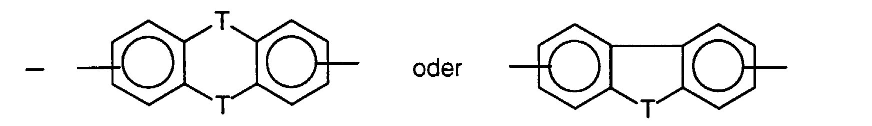 mit T = CH₂, CF₂, CO, O, S, NH oder N(CH₃); 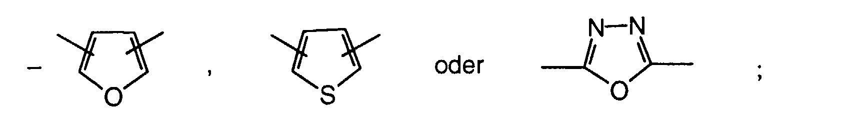 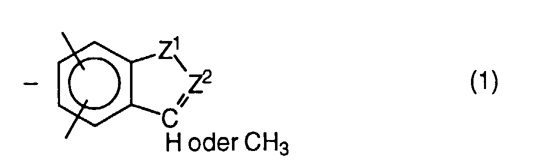 mit
(a) Z¹ = CH₂ oder CH(CH₃) und Z² = CH oder C(CH₃)
(b) Z¹ = CH₂ oder CH(CH₃) und Z² = N
(c) Z¹ = NH oder N(CH₃) und Z² = CH oder C(CH₃)
(d) Z¹ = NH oder N(CH₃) und Z² = N 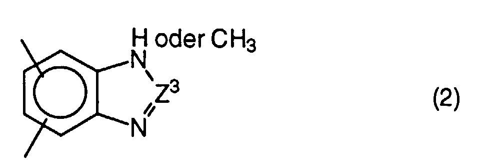
mit
(a) Z³ = CH oder C(CH₃)
(b) Z³ = N 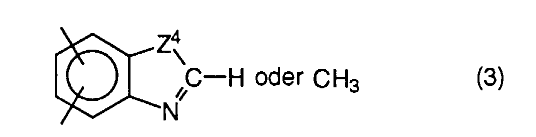
mit
(a) Z⁴ = O
(b) Z⁴ = S;
wobei an allen aromatischen Partialstrukturen jeweils sämtliche Wasserstoffatome (H) durch Fluor (F) ersetzt sein können.

Die Erfindung löst das vorstehend geschilderte Problem in der Weise, daß als Dicarbonsäurekomponente spezielle gemischte Dianhydride eingesetzt werden, und zwar gemischte Dianhydride aus einer Dicarbonsäure und einer Sulfonsäure. Überraschenderweise ergibt sich hierbei eine ausreichende Selektivität der Amidbildung. Die erfindungsgemäß hergestellten Polymere, d.h. die Poly-o-hydroxy- und Poly-o-mercaptoamide, sind nämlich in metallionenfreien wäßrig-alkalischen Entwicklern löslich. Außerdem läuft das Verfahren nach der Erfindung ohne Gelbildung ab, so daß die genannten Polymere in organischen Lösungsmitteln gut löslich und verarbeitbar sind. Ferner werden bei diesem Verfahren Verunreinigungen wie Chlorid- und Metallionen sowie Phosphorverbindungen vermieden.

Zur Synthese der Polymere dienen spezielle gemischte Dianhydride aus Dicarbonsäuren und Sulfonsäuren, insbesondere einer Toluolsulfonsäure, vorzugsweise p-Toluolsulfonsäure. Es können aber auch andere Sulfonsäuren, wie Methan- und Trifluormethansulfonsäure, Benzolsulfonsäuren, Perfluorbenzolsulfonsäure und Naphthalinsulfonsäuren, eingesetzt werden.

Zur Synthese der Vorstufen werden vorzugsweise gemischte Dianhydride mit Dicarbonsäuren wie 1,3-Benzoldicarbonsäure (Isophthalsäure) und Diphenylether-4,4'-dicarbonsäure (Oxydibenzoesäure) eingesetzt. Es kann jedoch allgemein auf solche Dicarbonsäuren zurückgegriffen werden, wie sie zur Herstellung von Vorstufen der genannten Art Verwendung finden.

Besonders geeignete Bis-o-aminophenole sind 2,2-Bis-(3-amino-4-hydroxyphenyl)-hexafluorpropan und 3,3'-Dihydroxy-4,4'-di-aminodiphenyl. Zur Synthese von Poly-o-mercaptoamiden dienen die entsprechenden Bis-o-aminothiophenole. Prinzipiell können aber alle Bis-o-aminophenole und -thiophenole eingesetzt werden, die üblicherweise zur Herstellung von Polybenzoxazol- bzw. Polybenzothiazol-Vorstufen Verwendung finden.

Die Umsetzung des Dianhydrids mit dem Bis(thio)phenol erfolgt vorteilhaft in Gegenwart eines basischen Katalysators, der vorzugsweise ein tertiäres Amin ist. Derartige Katalysatoren sind insbesondere Pyridin, Triethylamin, Diazabicyclooctan und Polyvinylpyridin. Es können aber auch andere basische Katalysatoren verwendet werden, wobei solche bevorzugt sind, welche in dem bei der Synthese der Vorstufe verwendeten Lösungsmittel, wie N-Methylpyrrolidon, oder in Wasser bzw. Wasser/Alkohol-Mischungen (Fällungsmittel) gut löslich sind, oder solche, welche vollkommen unlöslich sind, wie vernetztes Polyvinylpyridin. Es hat sich als vorteilhaft erwiesen, wenn - bezogen auf das Dianhydrid - mindestens die vierfache Menge (in Mol) an basischem Katalysator eingesetzt wird.

Die Reaktionstemperatur bei der Umsetzung zwischen dem Dianhydrid und dem (Thio)phenol ist ≤ 0°C. Für die Reaktionsselektivität hat es sich dabei als vorteilhaft erwiesen, wenn die Reaktionstemperatur ≤ -5°C beträgt.

Das Verfahren nach der Erfindung wird deshalb vorteilhaft in der Weise durchgeführt, daß das Bis-o-aminophenol bzw. -thiophenol und ein basischer Katalysator bei Raumtemperatur in einem organischen Lösungsmittel gelöst werden und die Lösung auf ca. -10°C abgekühlt wird. Zu dieser Lösung wird dann eine Lösung des Dianhydrids in einem organischen Lösungsmittel in der Weise zugegeben, daß die Temperatur nicht über -5°C steigt. Nach beendeter Zugabe wird die Reaktionslösung mindestens drei Stunden auf einer Temperatur von 20 bis 25°C gehalten und dann wird das Reaktionsprodukt mit einem geeigneten Fällungsmittel ausgefällt. Nach Filtration und Trocknung ist das ausgefällte Polymer einsatzfähig. Beim Verfahren nach der Erfindung erübrigen sich somit umständliche Reinigungsschritte, wie die Reinigung des Polymers mittels Ionenaustauscher.

Geeignete Lösungsmittel sind im übrigen N-Methylpyrrolidon, Tetrahydrofuran und N,N-Dimethylacetamid. Prinzipiell kann jedoch jedes Lösungsmittel verwendet werden, in dem die Ausgangskomponenten gut löslich sind. Als Fällungsmittel sind Wasser und Mischungen von Wasser mit Alkoholen wie Ethanol und Isopropanol besonders geeignet.

Beim Verfahren nach der Erfindung können - bei einem Überschuß an Bis-o-aminophenol oder -thiophenol - die Aminoendgruppen des hergestellten Poly-o-hydroxyamids bzw. -mercaptoamids vor dem Ausfällen des Polymers mit einem Dicarbonsäureanhydrid verkappt, d.h. blockiert werden. Hierzu eignet sich insbesondere cis-5-Norbornen-endo-2,3-dicarbonsäureanhydrid.

Aus der US-PS 3 637 601 ist es bekannt, schwefelhaltige Polyester und Polyamide durch Umsetzung eines gemischten Dianhydrids einer Dicarbonsäure und einer Sulfonsäure mit einem Glycol und/oder einem Diamin in Gegenwart einer Base herzustellen. Die Umsetzung erfolgt bei 10 bis 150°C, wobei Polymere mit einem Schwefelgehalt von 0,01 bis 8 Gew.-% erhalten werden. Derartige Polymere mit Schwefel in der Polymerkette sind aber für Anwendungen in der Mikroelektronik ungünstig, weil sie einerseits Korrosion verursachen können und andererseits in reduzierenden Medien, wie sie bei der Halbleiterfertigung vorkommen, zu Kontaktbelägen führen können und dann die Zuverlässigkeit elektrischer Kontaktierungen beeinträchtigen. Außerdem zeigt sich, daß das bekannte Verfahren zur Herstellung alkalilöslicher Vorstufen ungeeignet ist, es ergibt sich nämlich keine ausreichende Selektivität der Amidbildung (siehe dazu nachfolgend Beispiel 2).

Anhand von Ausführungsbeispielen soll die Erfindung noch näher erläutert werden.

### Beispiel 1

Zur Herstellung einer PBO-Vorstufe wird folgendermaßen vorgegangen. 4,64 g 2,2-Bis-(3-amino-4-hydroxyphenyl)-hexafluor-propan (12,7 mmol) werden unter Rühren in 50 ml Tetrahydrofuran gelöst, dann werden 4,01 g Pyridin (50,7 mmol) zugegeben. Die dabei erhaltene Lösung wird auf -10°C abgekühlt, dann wird dazu unter Rühren eine Lösung von 4,81 g eines Dianhydrids von Isophthalsäure und p-Toluolsulfonsäure (10,1 mmol) in 150 ml Tetrahydrofuran in der Weise zugetropft, daß die Temperatur der Reaktionslösung -5°C nicht übersteigt. Nach beendeter Zugabe wird die Reaktionslösung noch 4 h bei einer Temperatur von 20 bis 25°C gerührt.

Anschließend werden die Endgruppen blockiert, wobei zur Reaktionslösung bei 10°C innerhalb von 15 min eine Lösung von 0,83 g cis-5-Norbornen-endo-2,3-dicarbonsäureanhydrid in 15 ml Tetrahydrofuran getropft und dann 20 h bei 20 bis 25°C gerührt wird. Die dabei erhaltene Reaktionslösung wird abfiltriert und das entstandene Poly-o-hydroxyamid mit 1600 ml eines Gemisches aus Isopropanol und Wasser (Volumenverhältnis 1:3) ausgefällt. Der Niederschlag wird abfiltriert, zweimal mit je 400 ml Wasser gewaschen und im Vakuumschrank 72 h bei 50°C getrocknet. Die Verkappung der Endgruppen übt keinen Einfluß auf die Polymerisation aus, sie wird nur durchgeführt, um insbesondere die thermische Formbeständigkeit des Polymers während der Cyclisierung durch eine Vernetzung zu verbessern; die Verkappung kann deshalb auch unterbleiben.

Das IR-Spektrum des Poly-o-hydroxyamids zeigt eindeutig nur Amidbanden (bei 1654 cm⁻¹ und 1539 cm⁻¹), aber keine Esterbande. Die Elementaranalyse des Polymers ergibt die theoretischen Werte, d.h. 58,37 % Kohlenstoff, 3,69 % Wasserstoff und 4,75 % Stickstoff; Schwefel ist nicht nachweisbar.

Das Poly-o-hydroxyamid ist in einem kommerziellen wäßrig-alkalischen, metallionenfreien Entwickler (NSD-TD, Fa. Tokyo Ohka) klar löslich (0,5 g in 10 ml). Zur Herstellung von Filmen werden 2,5 g des Poly-o-hydroxyamids in 7,5 g N-Methylpyrrolidon gelöst, die entstandene Lösung wird dann durch ein 1 um-Filter filtriert und mittels Schleudertechnik auf einen Siliciumwafer aufgebracht. Nach dem Trocknen auf einer Heizplatte bei 115°C wird auf dem Wafer ein gleichmäßiger fehlerfreier Polymerfilm mit einer Schichtdicke von 1400 nm erhalten.

### Beispiel 2 (Vergleichsversuch)

Zu einer Lösung von 4,64 g 2,2-Bis-(3-amino-4-hydroxyphenyl)-hexafluorpropan (12,7 mmol) und 1,63 g Pyridin (20,6 mmol) in 50 ml Tetrahydrofuran wird bei 20 bis 25°C eine Lösung von 4,81 g eines Dianhydrids von Isophthalsäure und p-Toluolsulfonsäure (10,1 mmol) in 150 ml Tetrahydrofuran getropft und die Reaktionslösung 4 h bei 20 bis 25°C gerührt. Anschließend erfolgt eine Verkappung der Endgruppen wie in Beispiel 1 und dann wird die Reaktionslösung in entsprechender Weise aufgearbeitet.

Das IR-Spektrum des dabei erhaltenen Polymers zeigt neben den Amidbanden eine deutliche Esterbande (bei 1751 cm⁻¹). Bei der Herstellung von Polymerfilmen entsprechend Beispiel 1 zeigt sich, daß diese fehlerhaft und somit unbrauchbar sind. Außerdem sind bereits 0,2 g des Polymers in 10 ml des Entwicklers nicht vollständig löslich.

## Patentansprüche

1. Verfahren zur Herstellung von Poly-o-hydroxyamiden und Poly-o-mercaptoamiden, **dadurch gekennzeichnet**, daß ein Bis-o-aminophenol bzw. ein Bis-o-aminothiophenol bei einer Temperatur ≤ 0°C mit einem gemischte Dianhydrid aus einer Dicarbonsäure und einer Sulfonsäure und mit folgender Struktur umgesetzt wird:
E-SO₂-O-CO-R*-CO-O-SO₂-E ,
wobei folgendes gilt: 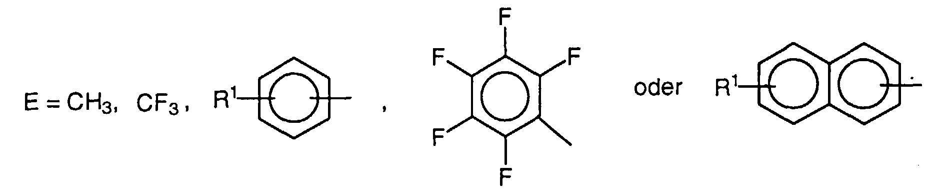 mit R¹ = H, F, CH₃ oder CF₃;
R* hat folgende Bedeutung:
- (CR₂)ₘ mit R = H, F, CH₃ oder CF₃
und m = 1 bis 10; 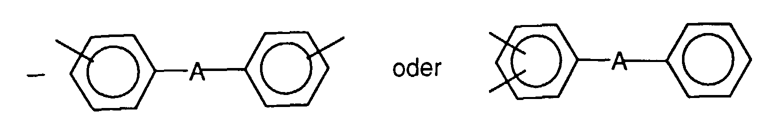 mit
A = (CH₂)ₙ, (CF₂)ₚ, C(CH₃)₂, C(CF₃)₂, C(CH₃)(C₆H₅), C(CF₃)(C₆H₅), C(CF₃)(C₆F₅), C(C₆H₅)₂, CF₂-CF (CF₃), CH=CH, CF=CF, C≡C, O-C₆H₄-O, O, S, CO oder SO₂, wobei n = 0 bis 10 und p = 1 bis 10; 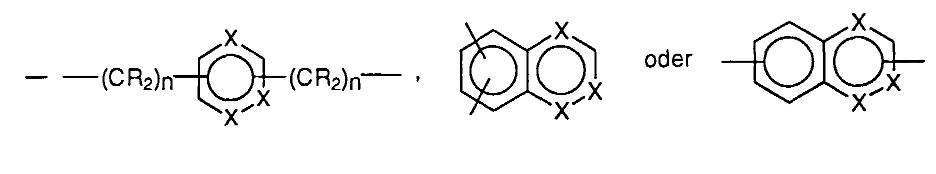
mit
X = CH oder N
R = H, F, CH₃ oder CF₃
und n = 0 bis 10; 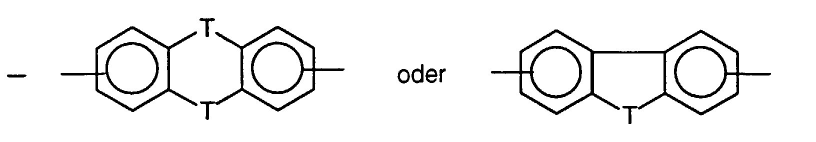 mit T = CH₂, CF₂, CO, O, S, NH oder N(CH₃); 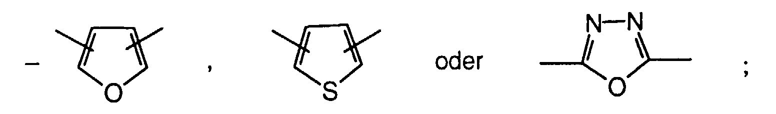 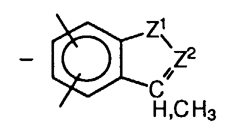 mit
Z¹ = CH₂ oder CH(CH₃) und Z² = CH oder C(CH₃)
Z¹ = CH₂ oder CH(CH₃) und Z² = N
Z¹ = NH oder N(CH₃) und Z² = CH oder C(CH₃)
Z¹ = NH oder N(CH₃) und Z² = N 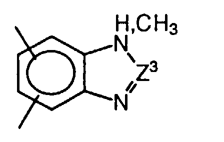
mit Z³ = CH, C(CH₃) oder N 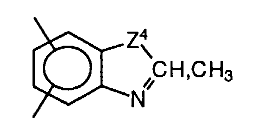 mit Z⁴ = O oder S;
wobei an allen aromatischen Partialstrukturen jeweils sämtliche Wasserstoffatome (H) durch Fluor (F) ersetzt sein können.

2. Verfahren nach Anspruch 1, **dadurch gekennzeichnet**, daß ein Dianhydrid aus Isophthalsäure und p-Toluolsulfonsäure eingesetzt wird.

3. Verfahren nach Anspruch 1 oder 2, **dadurch gekennzeichnet**, daß die Umsetzung in Gegenwart eines basischen Katalysators erfolgt.

4. Verfahren nach Anspruch 3, **dadurch gekennzeichnet**, daß der Katalysator ein tertiäres Amin ist.

5. Verfahren nach Anspruch 3 oder 4, **dadurch gekennzeichnet**, daß der Katalysator in einer Menge von mindestens 400 Mol-% eingesetzt wird, bezogen auf das Dianhydrid.

6. Verfahren nach einem der Ansprüche 1 bis 5, **dadurch gekennzeichnet**, daß die Umsetzung bei einer Temperatur von ≤ -5°C durchgeführt wird.

## Claims

1. Process for preparing poly-o-hydroxyamides and poly-o-mercaptoamides, characterized in that a bis-o-aminophenol or a bis-o-aminothiophenol is reacted at a temperature of ≤ 0°C with a mixed dianhydride of a dicarboxylic acid and a sulphonic acid having the following structure: 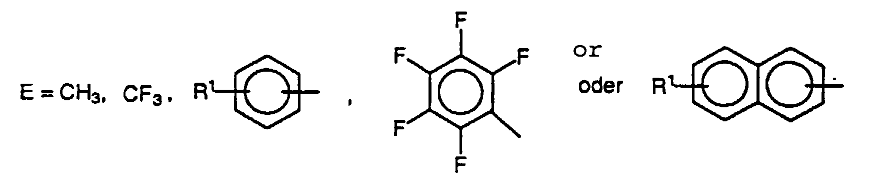 where: 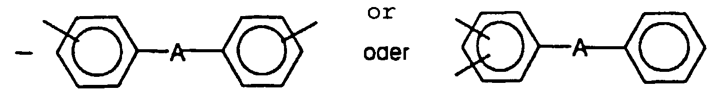 where R¹, H, F, CH₃ or CF₃;
R* has the following meaning:
- (CR₂)ₘ where R = H, F, CH₃ or CF₃
and m = 1 to 10; 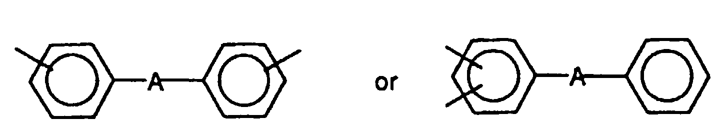 where
A = (CH₂)ₙ, (CF₂)ₚ, C(CH₃)₂, C(CF₃)₂, C(CH₃) (C₆H₅), C(CF₃(C₆H₅), C(CF₃) (C₆F₅), C(C₆H₅)₂, CF₂-CF(CF₃), CH=CH, CF=CF, C≡C, O-C₆H₄-O, O, S, CO or SO₂, where n = 0 to 10 and p = 1 to 10; 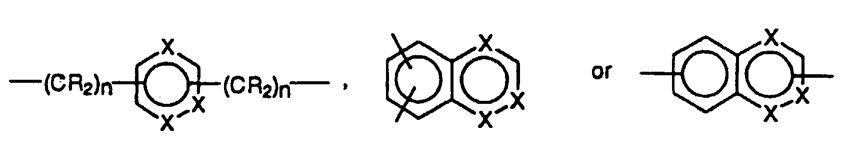
where
X = CH or N
R = H, F, CH₃ or CF₃
and n = 0 to 10; 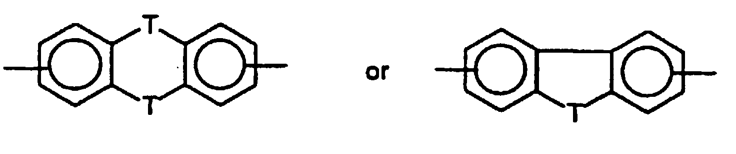 where T = CH₂, CF₂, CO, O, S, NH or N(CH₃); 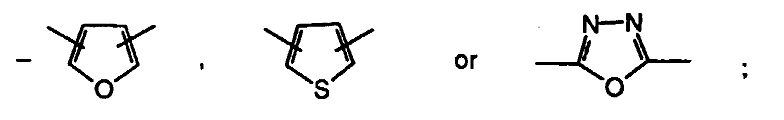 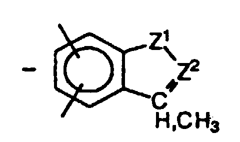 where
Z¹ = CH₂ or CH(CH₃) and Z² = CH or C(CH₃)
Z¹ = CH₂ or CH(CH₃) and Z² = N
Z¹ = NH or N(CH₃) and Z² = CH or C(CH₃)
Z¹ = NH or N(CH₃) and Z² = N 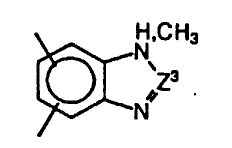
where Z³ = CH, C(CH₃) or N 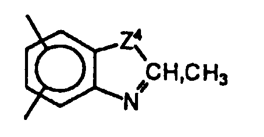 where Z⁴ = O or S;
where all hydrogen atoms (H) can in each case be replaced by fluorine (F) in all aromatic substructures.

2. Process according to Claim 1, characterized in that a dianhydride of isophthalic acid and p-toluenesulphonic acid is used.

3. Process according to Claim 1 or 2, characterized in that the reaction is carried out in the presence of a basic catalyst.

4. Process according to Claim 3, characterized in that the catalyst is a tertiary amine.

5. Process according to Claim 3 or 4, characterized in that the catalyst is used in an amount of at least 400 mol %, based on the dianhydride.

6. Process according to any of Claims 1 to 5, characterized in that the reaction is carried out at a temperature of ≤ -5°C.

## Revendications

1. Procédé pour la préparation de poly-o-hydroxyamides et de poly-o-mercaptoamides, caractérisé en ce qu'on fait réagir un bis-o-aminophénol, respectivement un bis-o-aminothiophénol à une température ≤ 0°C avec un dianhydride mixte constitué d'un acide dicarboxylique et d'un acide sulfonique et possédant la structure ci-après:
E-SO₂-O-CO-R*-CO-O-SO₂-E
dans laquelle:
E représente un groupe CH₃, un groupe CF₃, un groupe 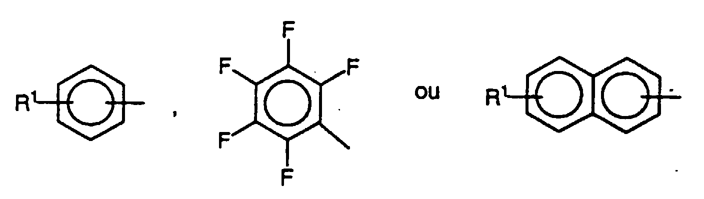 où R¹ représente un atome d'hydrogène, un atome de fluor, un groupe CH₃ ou un groupe CF₃;
R* a la signification ci-après:
- un groupe (CR₂)ₘ où R représente un atome d'hydrogène, un atome de fluor, un groupe CH₃ ou un groupe CF₃ et m = 1 à 10; 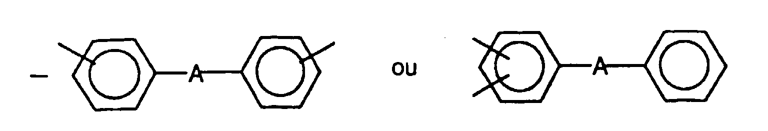 où A représente un groupe (CH₂)ₙ, un groupe (CF₂)ₚ, un groupe C(CH₃)₂, un groupe C(CF₃)₂, un groupe C(CH₃)(C₆H₅), un
groupe C(CF₃)(C₆H₅), un groupe C(CF₃)(C₆F₅), un groupe C(C₆H₅)₂, un groupe CF₂-CF(CF₃), un groupe CH=CH, un groupe CF=CF, un groupe C≡C, un groupe O-C₆H₄-O, un atome d'oxygène, un atome de soufre, un groupe CO ou un groupe SO₂, où n = 0 à 10 et p = 1 à 10; 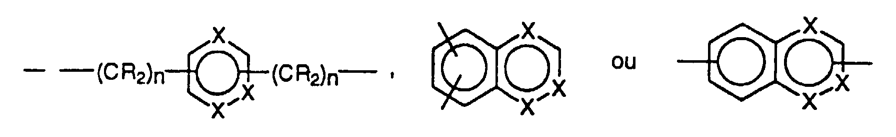 où
X représente un groupe CH ou un atome d'azote
R représente un atome d'hydrogène, un atome de fluor, un groupe CH₃ ou un groupe CF₃
et n = 0 à 10; 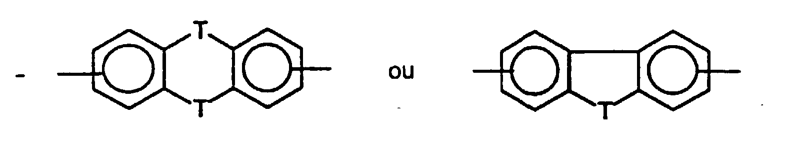 où T représente un groupe CH₂, un groupe CF₂, un groupe CO, un atome d'oxygène, un atome de soufre, un groupe NH ou un groupe N(CH₃); 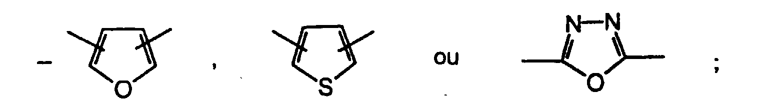 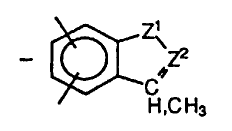 où
Z¹ représente un groupe CH₂ ou un groupe CH(CH₃) et Z² représente un groupe CH ou un groupe C(CH₃);
Z¹ représente un groupe CH₂ ou un groupe CH(CH₃) et Z² représente un atome d'azote;
Z¹ représente un groupe NH ou un groupe N(CH₃) et Z² représente un groupe CH ou un groupe C(CH₃);
Z¹ représente un groupe NH ou un groupe N(CH₃) et Z² représente un atome d'azote 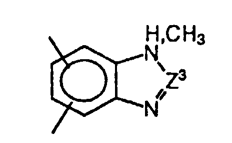
où Z³ représente un groupe CH, un groupe C(CH₃) ou un atome d'azote 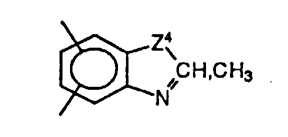 où Z⁴ représente un atome d'oxygène ou un atome de soufre;
dans lequel, sur toutes les structures partielles aromatiques, tous les atomes d'hydrogène (H) respectivement peuvent être remplacés par des atomes de fluor (F).

2. Procédé selon la revendication 1, caractérisé en ce qu'on met en oeuvre un dianhydride d'acide isophtalique et d'acide p-toluènesulfonique.

3. Procédé selon la revendication 1 ou 2, caractérisé en ce que la mise en réaction a lieu en présence d'un catalyseur basique.

4. Procédé selon la revendication 3, caractérisé en ce que le catalyseur est une amine tertiaire.

5. Procédé selon la revendication 3 ou 4, caractérisé en ce qu'on met en oeuvre le catalyseur en une quantité d'au moins 400 moles %, rapportée au dianhydride.

6. Procédé selon l'une quelconque des revendications 1 à 5, caractérisé en ce qu'on effectue la mise en réaction à une température ≤ -5°C.
